# EUROPEAN PATENT APPLICATION

(11) **EP 4 830 885 A1**
(43) Date of publication of application: **28.10.2026**
(21) Application number: 24907501.1
(22) Date of filing: 19.12.2024
(51) Int. Cl.: B25J 19/00, B25J 17/00

(54) **REDUCTION GEAR SELECTION ASSISTANCE DEVICE**

(30) Priority: 22.12.2023 JP 2023217399
(71) Applicant: Sumitomo Heavy Industries, Ltd., Tokyo 141-6025 (JP)
(72) Inventor: TANAKA, Mitsuharu, Yokosuka-shi, Kanagawa 237-8555 (JP)
(74) Representative: Louis Pöhlau Lohrentz
(86) International application number: PCT/JP2024/044977
(87) International publication number: WO 2025/135117

(57) **Abstract**

A speed reducer selection assistive device 100 includes a storage unit that stores, in association with information enabling a type of a speed reducer to be specified, characteristic information of the speed reducer, a first reception unit 121 that receives specification information of a robot, a second reception unit 122 that receives designation of a speed reducer to be incorporated into each joint of the robot, a third reception unit 123 that receives an operation condition of the robot, a life estimating unit 130 that estimates a life of the speed reducer in a case where the robot in which the designated speed reducer is incorporated into each joint is operated under a designated operation condition, and an estimated life providing unit 131 that provides a user with an estimation result by the life estimating unit 130.

## Description

### Technical Field

The present invention relates to a speed reducer selection assistive device.

### Background Art

A robot is known in which a speed reducer is incorporated into a plurality of joint portions. For example, PTL 1 discloses a robot in which an eccentric oscillating type reduction gear is incorporated into a joint portion.

### Citation List

### Patent Literature

[PTL 1] Japanese Unexamined Patent Publication No. 2006-263878

### Summary of Invention

### Technical Problem

A speed reducer to be incorporated into each joint is selected in a case where a robot is designed, but the selection is very laborious.

The present invention has been made in view of such circumstances, and an object of the present invention is to provide a technique of assisting selection of a speed reducer.

### Solution to Problem

In order to solve the above problem, a speed reducer selection assistive device according to an aspect of the present invention includes a storage unit that stores, in association with information enabling a type of a speed reducer to be specified, characteristic information of the speed reducer, the characteristic information changing according to a situation change of the speed reducer, a first reception unit that receives specification information of a robot, a second reception unit that receives designation of a speed reducer to be incorporated into each joint of the robot, a third reception unit that receives an operation condition of the robot, a life estimating unit that estimates a life of the speed reducer in a case where the robot in which the designated speed reducer is incorporated into each joint is operated under a designated operation condition, and an estimated life providing unit that provides a user with an estimation result by the life estimating unit.

Another aspect of the present invention is also a speed reducer selection assistive device. This device includes a storage unit that stores, in association with information enabling a type of a speed reducer to be specified, characteristic information of the speed reducer, the characteristic information changing according to a situation change of the speed reducer, a first reception unit that receives specification information of a robot, a third reception unit that receives an operation condition of the robot, a life estimating unit that estimates lives of a plurality of speed reducers in a case where the robot is operated under a designated operation condition, and a speed reducer proposing unit that proposes, based on estimation results of the lives by the life estimating unit, one or a plurality of speed reducers to a user.

Any combination of the components described above and a combination obtained by switching the components and expressions of the present invention between methods, devices, and systems are also effective as an aspect of the present invention.

### Advantageous Effects of Invention

According to the present invention, it is possible to provide the technique of assisting the selection of the speed reducer.

### Brief Description of Drawings

FIG. 1 is a schematic diagram showing a configuration of a speed reducer selection assistive system according to a first embodiment.
FIG. 2 is a block diagram showing functions and a configuration of a speed reducer selection assistive device of FIG. 1.
FIG. 3 is a diagram showing an example of a selection assistive screen provided by a screen providing unit in FIG. 2.
FIG. 4 is a graph showing an example of an analysis result provided to a user.
FIG. 5 is a graph showing another example of the analysis result provided to the user.
FIG. 6 is a graph showing still another example of the analysis result provided to the user.
FIG. 7 is a table showing an example of an estimation result screen provided to the user.
FIG. 8 is a block diagram showing functions and a configuration of a speed reducer selection assistive device according to a second embodiment.
FIG. 9 is a diagram showing an example of a selection assistive screen provided by a screen providing unit in FIG. 8.

### Description of Embodiments

Hereinafter, the same reference numerals will be assigned to the same or equivalent components, members, and processes in drawings, and overlapping description thereof will be omitted as appropriate. Further, dimensions of the members in each drawing are shown enlarged or reduced as appropriate for easy understanding. Further, some members that are not important for describing the embodiment will be omitted in each drawing.

First, background leading to the present invention will be described. A speed reducer to be incorporated into each joint is selected in a case where a robot is designed. In the speed reducer selection, a life of a speed reducer is estimated in a case where a robot in which the speed reducer, serving as a candidate, is incorporated into the joint is operated under a designated operation condition. The life can be estimated, for example, by using a life calculation equation described in a catalog. However, in order to estimate the life, it is necessary to calculate a load or the like applied to the speed reducer in a case where the robot is operated under the designated operation condition, and then extract a value to be input to the life calculation equation from the calculated load or the like, which places a large burden on a user. The present invention has been made, based on such a finding, to assist the selection of the speed reducer.

(First Embodiment) An outline will be described before a first embodiment is described in detail. The first embodiment relates to a technique of assisting selection of a speed reducer to be incorporated into a joint of a robot. A speed reducer selection assistive device of the first embodiment provides a selection assistive screen on a user terminal. The user terminal receives an input to the selection assistive screen from the user. The input to the selection assistive screen includes specification information of a robot under design, designation of a speed reducer (model number or specification) desired to be incorporated into a joint of the robot, and an operation condition of the robot. The speed reducer selection assistive device receives the above inputs. The speed reducer selection assistive device estimates a life of a speed reducer in a case where a robot having the received specification, in which the designated speed reducer is incorporated into the joint, is operated under the received operation condition. The speed reducer selection assistive device provides an estimation result of the life to the user terminal. The user can refer to the estimation result in the selection of the speed reducer.

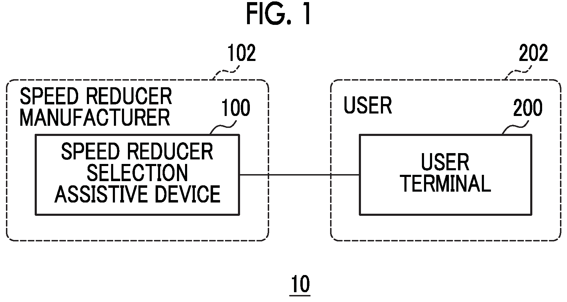

FIG. 1 is a schematic diagram showing a configuration of a speed reducer selection assistive system 10 of the first embodiment. The speed reducer selection assistive system 10 includes a speed reducer selection assistive device 100 and a user terminal 200. The speed reducer selection assistive device 100 is connected to the user terminal 200, via a network such as the Internet.

The speed reducer selection assistive device 100 is an information processing device managed by a speed reducer manufacturer 102. The speed reducer manufacturer 102 is a company that manufactures the speed reducer. The speed reducer is a reduction gear or a gear motor (device in which reduction gear is connected to motor). The term "managed by speed reducer manufacturer 102" herein includes not only a case where the management is directly performed by the speed reducer manufacturer 102, but also a case where the management is performed by a company entrusted by the speed reducer manufacturer 102.

The speed reducer selection assistive device 100 is configured by a single device (casing) in the present embodiment, but the number of physical casings of the speed reducer selection assistive device 100 is not limited. The speed reducer selection assistive device 100 may be realized by cooperation between a plurality of devices.

The user terminal 200 is an information processing terminal used by a user 202, and is a general PC, a tablet terminal, or a smartphone, for example. The user 202 is not particularly limited, but is typically a robot manufacturer. That is, the user 202 selects the speed reducer to be incorporated into the joint of the robot.

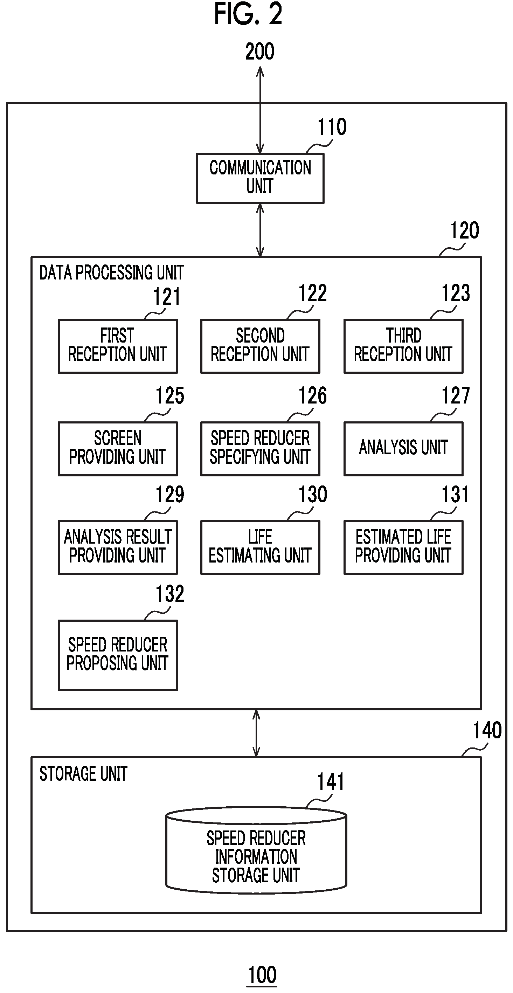

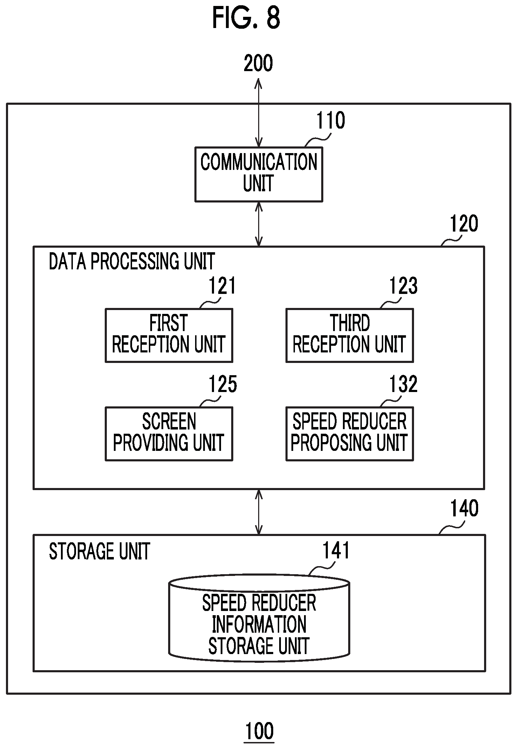

FIG. 2 is a block diagram showing functions and a configuration of the speed reducer selection assistive device 100. Each block shown here can be realized by elements such as a central processing unit (CPU) of a computer or a machine device in terms of hardware, and can be realized by a computer program or the like in terms of software. Here, functional blocks realized in cooperation between the hardware and the software are illustrated. Therefore, it is understood by those skilled in the art given this specification that such functional blocks can be implemented in various manners through combination between hardware and software. The same applies to a block diagram of FIG. 8.

The speed reducer selection assistive device 100 includes a communication unit 110, a data processing unit 120, and a storage unit 140. The communication unit 110 executes communication processing with the user terminal 200 according to various communication protocols. The data processing unit 120 executes various types of data processing based on data acquired by the communication unit 110 or data stored in the storage unit 140. The storage unit 140 stores various types of data prepared in advance or the data received from the communication unit 110 or the data processing unit 120.

The storage unit 140 includes a speed reducer information storage unit 141. The speed reducer information storage unit 141 stores, for each of a plurality of speed reducers, a speed reducer ID for uniquely identifying the speed reducer, information for specifying a type of the speed reducer (hereinafter also referred to as type specification information), and characteristic information of the speed reducer in association with each other. The type specification information includes a model, frame number, reduction ratio, and the like of the speed reducer.

In a case where the speed reducer is the reduction gear, the characteristic information includes the characteristic information of the reduction gear. In a case where the speed reducer is the gear motor, the characteristic information includes the characteristic information of both the reduction gear and a motor, which configure the gear motor. The characteristic information includes a friction, an angular transmission error, and the like. The characteristic information is not particularly limited, but is defined to change according to a change in a situation (for example, temperature or rotational speed) of the speed reducer. That is, the friction is defined as a function with at least the temperature and the rotational speed as variables. Similarly, the angular transmission error is defined as a function with at least a reduction gear rotation angle as a variable.

The speed reducer information storage unit 141 may store characteristic information on all speed reducers manufactured by the speed reducer manufacturer 102. Further, the speed reducer information storage unit 141 may store characteristic information on speed reducers that have been manufactured in the past (that is, manufacturing has been ended), in addition to characteristic information on speed reducers being manufactured.

The data processing unit 120 includes a first reception unit 121, a second reception unit 122, a third reception unit 123, a screen providing unit 125, a speed reducer specifying unit 126, an analysis unit 127, an analysis result providing unit 129, a life estimating unit 130, an estimated life providing unit 131, and a speed reducer proposing unit 132.

The screen providing unit 125 transmits a selection assistive screen, which is a screen assisting the selection of the speed reducer, to the user terminal 200 in response to a request, and displays the selection assistive screen on a display of the user terminal 200.

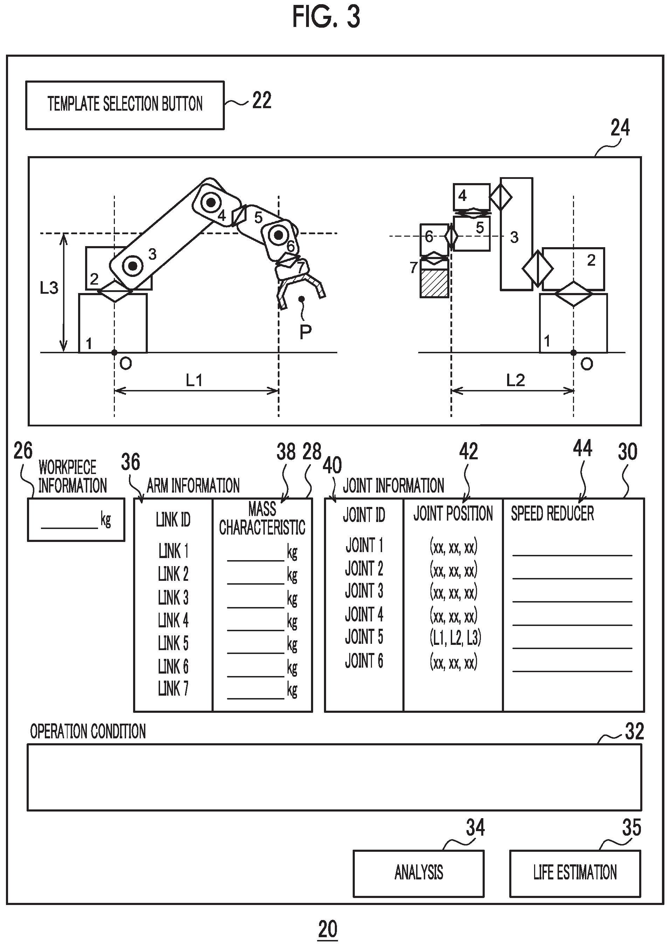

FIG. 3 is a diagram showing an example of the selection assistive screen 20 provided by the screen providing unit 125 in FIG. 2. The selection assistive screen 20 includes a template selection button 22, a robot display region 24, a workpiece information field 26, an arm information region 28, a joint information region 30, an operation condition field 32, an analysis button 34, and a life estimation button 35.

In a case where the template selection button 22 is selected, a list of templates prepared in advance (not shown) is displayed. The user selects, from the list of the displayed templates, a template corresponding to a robot to be configured. A schematic diagram of the robot of the selected template is displayed in the robot display region 24.

A mass characteristic of a workpiece is input into the workpiece information field 26. The mass characteristic is, for example, a weight, a centroid position, or a moment of inertia.

The arm information region 28 includes a link ID field 36 and a link mass characteristic field 38. The link ID field 36 displays an ID for identifying a link. The number of links of the robot is determined by the template selection. The mass characteristic of the link is input into the link mass characteristic field 38.

The joint information region 30 includes a joint ID field 40, a joint position field 42, and a speed reducer field 44. The joint ID field 40 displays an ID for identifying the joint (rotary shaft). The number of joints of the robot is determined by the template selection.

A three-dimensional position of each joint (rotary shaft) in a reference posture (for example, initial posture) of the robot with a predetermined reference point O (refer to the robot display region 24) as an origin is input into the joint position field 42. A default value set in the template may be input into the joint position field 42. In this case, the user may change the default value in the joint position field 42 by, for example, direct input as necessary. In the illustration displayed in the robot display region 24, the position of the joint may be changeable by an operation such as drag and drop, and the input into the joint position field 42 may be changed accordingly. That is, the input into the joint position field 42 may be performed in a form of the template change.

Information for designating the speed reducer to be incorporated into each joint, for example, a model, frame number, or specification information of the speed reducer is input into the speed reducer field 44. The specification information of the speed reducer includes, for example, the reduction ratio and a required torque. In a case where the speed reducer is the gear motor, the specification information of the speed reducer includes, for example, a moment of inertia of the motor and a maximum generated torque. A plurality of pieces of information, for example, a plurality of pieces of specification information for one joint may be input into the joint position field 42. For example, both the reduction ratio and the required torque for one joint may be input into the joint position field 42. In a case where the speed reducer does not include the motor, there may be a form in which the moment of inertia of the motor or the maximum generated torque is selected from the template in the same manner as the speed reducer, or there may be a form in which the user can individually designate the moment of inertia of the motor or the maximum generated torque.

An operation condition of the robot is input into the operation condition field 32. For example, the operation condition includes a start point and an end point at which a reference point P of a tool attached to a tip of an arm of the robot moves, a stopping time at each point, the presence or absence of a workpiece during the operation, and a speed and an acceleration at which the reference point P moves. Further, for example, the operation condition is a three-dimensional target path along which the reference point P moves. The operation condition may be input in a form set in advance for each type. A control method or a control parameter of the motor in a case where behavior analysis is performed may be in a user adjustable form. A condition for sequentially performing a plurality of operations may be provided. It is desirable that a series of operations is input as one cycle in life calculation, and thus a restriction may be made such that the start point matches the end point during the reception of the user input.

In a case where the analysis button 34 is selected, each information item in FIG. 3 is transmitted from the user terminal 200 to the speed reducer selection assistive device 100, and the analysis described below is executed in the speed reducer selection assistive device 100.

In a case where the life estimation button 35 is selected, each information item in FIG. 3 is transmitted from the user terminal 200 to the speed reducer selection assistive device 100, and life estimation described below is executed in the speed reducer selection assistive device 100.

The description returns to FIG. 2. The first reception unit 121 receives, from the user via the user terminal 200, specification information of the robot. Specifically, the first reception unit 121 receives, from the user terminal 200, the information items related to a specification of the robot on the selection assistive screen 20 in FIG. 3, specifically, the mass characteristic of the workpiece, the mass characteristic of the link, the number of joints, and a joint position of each joint.

The second reception unit 122 receives the designation of the speed reducer to be incorporated into each joint of the robot, from the user via the user terminal 200. Specifically, the second reception unit 122 receives, from the user terminal 200, the input to the speed reducer field 44 of the selection assistive screen 20 in FIG. 3.

The third reception unit 123 receives, from the user via the user terminal 200, the operation condition of the robot. Specifically, the third reception unit 123 receives, from the user terminal 200, the input into the operation condition field 32 of the selection assistive screen 20 in FIG. 3.

The speed reducer specifying unit 126 specifies the speed reducer, based on the designation of the speed reducer received by the second reception unit 122. Specifically, the speed reducer specifying unit 126 specifies, from the speed reducer information storage unit 141, the speed reducer ID of the speed reducer that matches the designation of the speed reducer, which is received by the second reception unit 122, and the characteristic information of the speed reducer. The plurality of speed reducers may be specified. For example, in a case where the information for designating the speed reducer is the specification information of the speed reducer, a plurality of speed reducers that match the specification information, that is, satisfy the specification information may be present. In this case, the speed reducer specifying unit 126 may specify the plurality of speed reducers.

In the analysis unit 127, the analysis is performed, by simulation, on the behavior in a case where the speed reducer specified by the speed reducer specifying unit 126, based on the designation received by the second reception unit 122, is incorporated into the joint of the robot having the specification received by the first reception unit 121, and then the robot is operated under the operation condition received by the third reception unit 123. In the analysis unit 127, the analysis is executed, for example, in a case where the analysis button 34 in FIG. 3 is selected. In the analysis unit 127, the analysis may be performed by using a known or future available analysis technique. In the above analysis, the analysis unit 127 uses the characteristic information stored in the speed reducer information storage unit 141, as the characteristic information of the speed reducer incorporated into each joint.

In a case where the speed reducer specifying unit 126 specifies the plurality of speed reducers for a certain joint, the analysis unit 127 may sequentially incorporate the plurality of speed reducers into the joint and analyze the behavior in each case.

The analysis result providing unit 129 provides the user with an analysis result by the analysis unit 127. The analysis result includes, for example, a deviation from a command value for a position of the reference point P of the tool attached to the tip of the arm of the robot, a deviation from a command value for a rotation angle of each joint (rotary shaft), and a comparison between a load applied to the speed reducer and an allowable load included in the characteristic information of the speed reducer. The analysis result providing unit 129 transmits, for example, an analysis result screen showing the analysis result to the user terminal 200 to display the analysis result screen on the display of the user terminal 200.

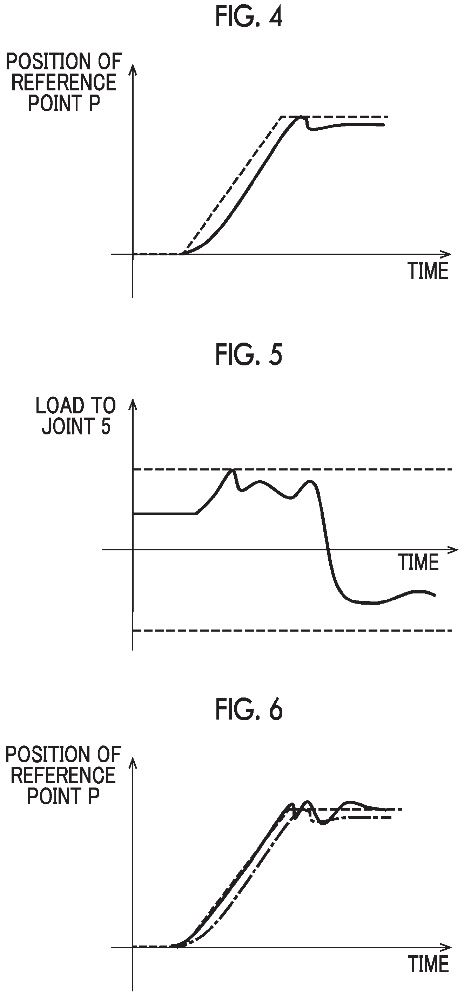

FIG. 4 is a graph showing an example of the analysis result provided to the user. The analysis result of this example is an error between the command value and the position of the reference point P in a case where the reference point P of the tool is moved along a target trajectory. In FIG. 4, the horizontal axis shows time, and the vertical axis shows the position of the reference point P of the tool. The graph of a solid line indicates the analysis result, and the graph of a broken line indicates the command value.

FIG. 5 is a graph showing another example of the analysis result provided to the user. In FIG. 5, the horizontal axis is time, and the vertical axis is the load applied to the joint, that is, the speed reducer. The graph of a solid line indicates the analysis result, and the graphs of broken lines indicate the allowable load of the speed reducer.

With checking of the analysis results in FIGS. 4 and 5, the user can understand at a glance the behavior of the robot in a case where the designated speed reducer is incorporated.

FIG. 6 is a graph showing still another example of the analysis result provided to the user. The analysis result of this example is an error between the command value and the position of the reference point P in a case where the reference point P of the tool is moved along the target trajectory, as in FIG. 4. This example shows the analysis result in a case where the speed reducer specifying unit 126 specifies a plurality of candidates for the speed reducer for a certain joint and the analysis unit 127 analyzes the behavior in each case. In the graph, a solid line and a one-dot chain line indicate the analysis results, and a broken line indicates the command value. The analysis result for each of the plurality of candidates is presented, and thus the user can select a more appropriate speed reducer.

The description returns to FIG. 2. The life estimating unit 130 estimates the life of the speed reducer in a case where the speed reducer specified by the speed reducer specifying unit 126, based on the designation received by the second reception unit 122, is incorporated into the joint of the robot having the specification received by the first reception unit 121, and then the robot is operated under the operation condition received by the third reception unit 123. For example, in a case where the life estimation button 35 of FIG. 3 is selected, the life estimation is executed. The life estimating unit 130 may use a known or future available estimation technique to estimate the life of the speed reducer. The life to be estimated is represented as a time until a failure in a case where the operation condition designated by the user is repeatedly performed. In a case where the robot includes a plurality of joints, the life estimating unit 130 may estimate the life of the candidate for the speed reducer of each joint.

For example, the life estimating unit 130 may use a known or future available life calculation equation to estimate the life. For example, the life calculation equation may include a rated life [h], a rated rotational speed [rpm], and a rated torque [Nm] of the speed reducer as parameters, and may include an average rotational speed [rpm] and an average load torque [Nm] of the speed reducer as variables. In this case, the life estimating unit 130 may substitute the average rotational speed and the average load torque, which are obtained by the analysis using the characteristic information stored in the speed reducer information storage unit 141, into the life calculation equation. A known or future available analysis technique is used for the analysis. The life estimating unit 130 or the analysis unit 127 may execute the analysis.

In a case where the speed reducer specifying unit 126 specifies a plurality of speed reducers for a certain joint, the life estimating unit 130 may sequentially perform the incorporation of the plurality of speed reducers and estimate the life of each speed reducer.

The estimated life providing unit 131 provides the user with the estimation result of the life of the speed reducer, which is estimated by the life estimating unit 130. The estimated life providing unit 131 transmits, for example, a life estimation result screen indicating the estimation result of the life to the user terminal 200 to display the life estimation result screen on the display of the user terminal 200.

The speed reducer proposing unit 132 determines whether or not the life of the speed reducer, which is estimated by the life estimating unit 130, satisfies a predetermined life condition. In a case where the estimated life does not satisfy the predetermined life condition, the speed reducer proposing unit 132 proposes another speed reducer different from the speed reducer to the user. The speed reducer proposing unit 132 transmits, for example, a proposal screen for proposing another speed reducer to the user terminal 200 to display the proposal screen on the display of the user terminal 200.

The predetermined life condition may be that the estimated life satisfies a life requirement set in advance. Specifically, the predetermined life condition may be that the estimated life (time) is equal to or larger than a generally required life (for example, 20,000 hours). Alternatively, the predetermined life condition may be that the estimated life is equal to or larger than the total number of operation cycles (for example, 1,000,000 cycles) in which a series of operation conditions input by the user is regarded as one cycle. Alternatively, the predetermined life condition may be that the estimated life is equal to or larger than the total number of operation cycles designated by the input from the user.

The predetermined life condition may be that the estimated life is equal to or larger than a required life designated by the user. The required life may be a time or a total rotational speed.

Another speed reducer is not particularly limited, but may be a speed reducer having a larger load capacity than the speed reducer designated by the user, that is, the speed reducer determined not to satisfy the predetermined life condition, typically, a larger speed reducer. In this case, another speed reducer may be all speed reducers having a larger load capacity than the speed reducer designated by the user, among all speed reducers stored in the speed reducer information storage unit 141.

Alternatively, another speed reducer may be a speed reducer having a larger load capacity than the speed reducer designated by the user and having a load capacity closest to the load capacity of the speed reducer designated by the user, among the plurality of speed reducers stored in the speed reducer information storage unit 141. That is, another speed reducer may be a speed reducer having a size larger than the speed reducer designated by the user, among the plurality of speed reducers stored in the speed reducer information storage unit 141.

For the speed reducer that does not satisfy the predetermined life condition, the speed reducer proposing unit 132 provides the user with the type specification information of another speed reducer proposed by the speed reducer proposing unit 132.

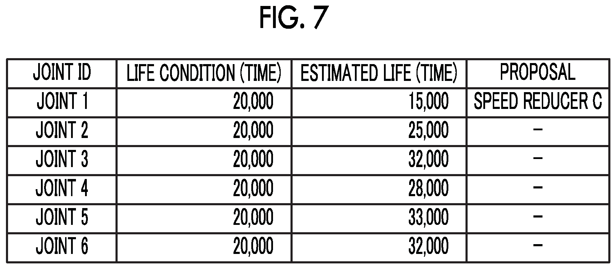

FIG. 7 is a table showing an example of a life estimation result screen provided to the user. The life estimation result screen of this example includes a joint ID of each joint, a life condition required for the speed reducer of each joint, an estimated life of the speed reducer of each joint designated by the user, and type specification information of another speed reducer proposed in a case where the life condition is not satisfied. In this example, the life estimation result screen also serves as the proposal screen for another speed reducer.

With checking of the life estimation result screen of FIG. 7, the user can understand at a glance the life of the speed reducer designated by the user, whether or not the life satisfies the life condition, and another speed reducer proposed in a case where the life condition is not satisfied.

The above is the configuration of the speed reducer selection assistive system 10. Subsequently, an operation thereof will be described. The speed reducer selection assistive device 100 provides the selection assistive screen 20 to the user terminal 200 in response to a request. The user inputs, to the selection assistive screen 20 via the user terminal 200, the specification information of the robot, the designation of the speed reducer to be incorporated into the robot, and the operation condition of the robot. In a case where the life estimation button 35 of the selection assistive screen 20 is selected, the user terminal 200 transmits each information item of the selection assistive screen 20 to the speed reducer selection assistive device 100. Each of the first reception unit 121, the second reception unit 122, and the third reception unit 123 of the speed reducer selection assistive device 100 receives the specification information of the robot, the designation of the speed reducer to be incorporated into the robot, and the operation condition of the robot. The analysis unit 127 estimates the life of the speed reducer in a case where the speed reducer specified based on the designation received by the second reception unit 122 is incorporated into the joint of the robot having the specification received by the first reception unit 121 and the robot is operated under the operation condition received by the third reception unit 123. In this case, the life estimating unit 130 performs, for example, the analysis using the characteristic information stored in the speed reducer information storage unit 141 and substitutes the average rotational speed and the average load torque obtained by the analysis into the life calculation equation to calculate the life of the speed reducer.

According to the present embodiment, the speed reducer selection assistive device 100 estimates the life of the speed reducer, based on the specification information of the robot received from the user, the designation of the speed reducer to be incorporated into the joint of the robot, the operation conditions of the robot, and the characteristic information of the speed reducer, and provides the user with the estimation result. Therefore, according to the present embodiment, it is possible to reduce the burden on the user for the life estimation of the speed reducer and the selection of the speed reducer.

Further, according to the present embodiment, in a case where the plurality of speed reducers that match the designation of the speed reducer from the user are present, the speed reducer selection assistive device 100 sequentially incorporates the plurality of speed reducers into the joint of the robot, estimates the life in each case, and provides the user with the estimation result. With the presentation of the estimation result of the life in a case where each of the plurality of candidates is incorporated, the user can select a more appropriate speed reducer.

Further, according to the present embodiment, the speed reducer selection assistive device 100 analyzes operation behavior of the robot, based on the specification information of the robot, the designation of the speed reducer, and the operation condition of the robot received from the user, and the characteristic information of the speed reducer, and provides the user with an analysis result thereof. Here, the speed reducer selection assistive device 100 stores, as the characteristic information of the speed reducer, the characteristic information that changes according to a situation change of the speed reducer, and executes the analysis in consideration of the situation change of the speed reducer. Therefore, according to the present embodiment, it is possible to execute the analysis with high accuracy while reducing the burden on the user, and thus appropriately select the speed reducer.

(Second Embodiment) In the first embodiment, the specification of the robot, the designation of the speed reducer to be incorporated into the robot, and the operation condition of the robot are received from the user, and the life of the speed reducer in a case where the robot in which the speed reducer is incorporated into the joint is operated under the operation condition is estimated and provided to the user. In a second embodiment, the specification of the robot and the operation condition of the robot are received from the user, and a speed reducer suitable for a case where the robot is operated under the operation condition is proposed. Hereinafter, differences from the first embodiment will be mainly described.

FIG. 8 is a block diagram showing functions and a configuration of the speed reducer selection assistive device 100 of the second embodiment. The data processing unit 120 of the speed reducer selection assistive device 100 of the second embodiment includes a first reception unit 121, a third reception unit 123, a screen providing unit 125, and a speed reducer proposing unit 132.

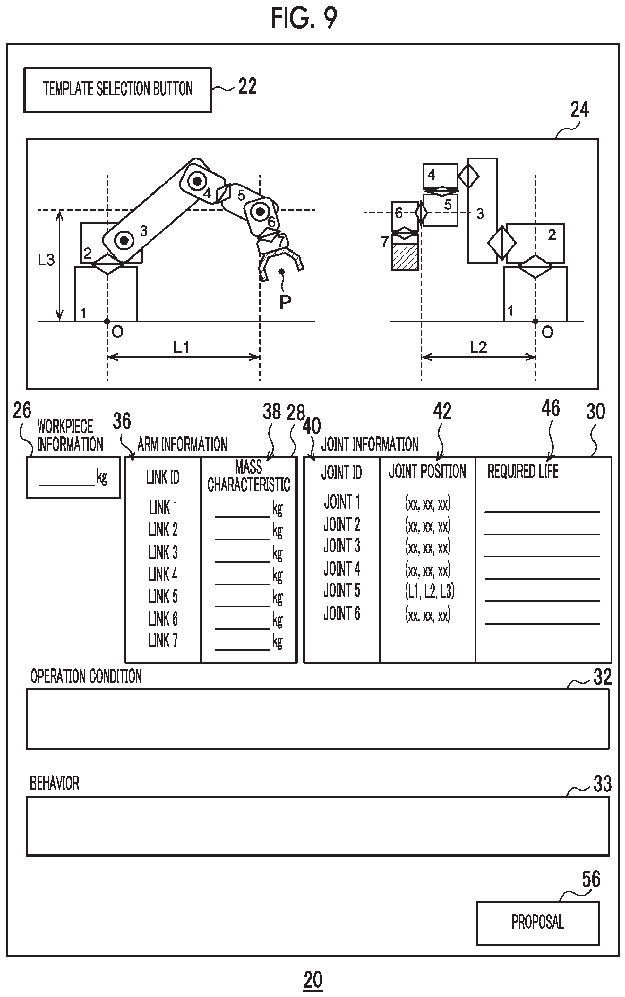

FIG. 9 is a diagram showing an example of the selection assistive screen 20 provided by the screen providing unit 125 in FIG. 8. The selection assistive screen 20 includes the template selection button 22, the robot display region 24, the workpiece information field 26, the arm information region 28, the joint information region 30, the operation condition field 32, behavior field 33, and a proposal button 56.

In the present embodiment, the joint information region 30 further includes a required life field 46. The required life of the speed reducer to be incorporated into each joint is input into the required life field 46.

The behavior of the robot desired to be realized in a case where the robot is operated under the operation condition input into the operation condition field 32 is input into the behavior field 33. For example, in a case where the operation condition includes the start point and the end point at which the reference point P of the tool attached to the tip of the arm of the robot moves, and the speed and the acceleration at which the reference point P moves, the behavior desired to be realized may be that the load applied to the speed reducer is equal to or less than a designated load, or a deviation from a command for a second position, which is a reaching position, may be equal to or less than a predetermined value. Further, for example, in a case where the operation condition is a three-dimensional target path, the behavior desired to be realized may be that the deviation from the command is equal to or less than a predetermined value. The behavior field 33 may be left blank.

In a case where the proposal button 56 is selected, each information item of FIG. 9 is transmitted from the user terminal 200 to the speed reducer selection assistive device 100, and the speed reducer selection assistive device 100 executes a proposal described below.

The description returns to FIG. 8. The third reception unit 123 of the present embodiment further receives the required life of the speed reducer to be incorporated into each joint of the robot. Specifically, the third reception unit 123 further receives the input into the required life field 46 of the selection assistive screen 20 of FIG. 9.

The life estimating unit 130 estimates the life of each of the plurality of speed reducers in a case where each of the plurality of speed reducers stored in the speed reducer information storage unit 141 is sequentially incorporated into the robot having the specifications received by the first reception unit 121 and the robot is operated under the operation condition received by the third reception unit 123.

The speed reducer proposing unit 132 proposes one or a plurality of speed reducers suitable for a case where the robot is operated under the operation condition received by the third reception unit 123, based on the estimation result of the life by the life estimating unit 130.

For example, the speed reducer proposing unit 132 may propose, as candidates, one or a plurality of speed reducers of which the estimated life is equal to or larger than the required life. In a case where there is one speed reducer of which the estimated life is equal to or larger than the required life, the speed reducer proposing unit 132 may propose, as a candidate, the one speed reducer. In a case where a plurality of speed reducers of which the estimated life is equal to or larger than the required life are present, the speed reducer proposing unit 132 may propose, as candidates, the plurality of speed reducers.

In a case where the required life is not input, the speed reducer proposing unit 132 may propose, as a candidate, a speed reducer having a longest estimated life.

Further, the third reception unit 123 may also receive the behavior desired to be realized in the robot. Specifically, in a case where the behavior desired to be realized in the robot is input into the behavior field 33 of the selection assistive screen 20 of FIG. 9, the third reception unit 123 may receive the input.

In this case, the speed reducer proposing unit 132 may analyze the behavior for each speed reducer in a case where each of the plurality of speed reducers stored in the speed reducer information storage unit 141 is sequentially incorporated into the robot having the specifications received by the first reception unit 121 and the robot is operated under the operation condition received by the third reception unit 123. The speed reducer proposing unit 132 may propose, as candidates, speed reducers having the estimated life that is equal to or larger than the required life and satisfying the behavior desired to be realized.

Subsequently, an operation of the speed reducer selection assistive device 100 will be described. The speed reducer selection assistive device 100 provides the selection assistive screen 20 to the user terminal 200 in response to a request. The user inputs, via the user terminal 200, the specification information of the robot, the operation condition of the robot, and the required life of the speed reducer to the selection assistive screen 20. In a case where the proposal button 56 of the selection assistive screen 20 is selected, the user terminal 200 transmits each information item of the selection assistive screen 20 to the speed reducer selection assistive device 100. The first reception unit 121 of the speed reducer selection assistive device 100 receives the specification information of the robot. The third reception unit 123 receives the operation condition of the robot and the required life of the speed reducer. The life estimating unit 130 estimates the life of each of the plurality of speed reducers in a case where each of the plurality of speed reducers stored in the speed reducer information storage unit 141 is sequentially incorporated into the robot having the specifications received by the first reception unit 121 and the robot is operated under the operation condition received by the third reception unit 123. The speed reducer proposing unit 132 proposes the candidate for the speed reducer, based on the estimation result of the life by the life estimating unit 130.

According to the present embodiment, the speed reducer selection assistive device 100 estimates the life of each of the plurality of speed reducers in a case where each of the plurality of speed reducers is sequentially incorporated in the robot having the specification received from the user and the robot is operated under the operation condition received from the user, and proposes a candidate of the speed reducer based on the estimation result. Therefore, according to the present embodiment, it is possible to select a more appropriate speed reducer while reducing the burden on the user.

The speed reducer selection assistive device 100 proposes, as a candidate, the speed reducer of which the estimated life is equal to or larger than the required life received from the user. According to the present embodiment, it is possible to select a more appropriate speed reducer.

The present invention has been described above based on the embodiments. It should be understood by those skilled in the art that the embodiments are mere examples, various modification examples can be made to the combinations of the respective components and respective processing processes, and such modification examples are also within the scope of the present invention. Such modification examples will be described below.

(First Modification Example) In the above embodiment, the case where the life estimating unit 130 estimates the life of the entire speed reducer has been described, but the life estimating unit 130 may estimate the life of each of a plurality of sites of the speed reducer.

The life estimating unit 130 may use a known or future available estimation technique to estimate the life of each of the plurality of sites. Life estimation means may be different for each of the plurality of sites. For example, the life estimating unit 130 may use a known or future available life calculation equation for each of the plurality of sites to estimate the life of each of the plurality of sites. The plurality of sites may be, for example, a main bearing such as a crossed roller bearing, an eccentric bearing, and a tooth surface of a gear.

The estimated life providing unit 131 may provide the user with the estimated life of each of the plurality of sites of the speed reducer. Alternatively, the estimated life providing unit 131 may provide the user with the estimated life of a site having a shortest estimated life among the plurality of sites of the speed reducer. That is, the estimated life providing unit 131 may provide the user with the estimated life of the site having the shortest estimated life among the plurality of sites of the speed reducer, as the estimated life of the speed reducer.

The speed reducer proposing unit 132 may determine whether or not the life of the site having the shortest estimated life, among the plurality of sites estimated by the life estimating unit 130, satisfies a predetermined life condition, and may propose a speed reducer different from the speed reducer to the user in a case where the shortest estimated life does not satisfy the predetermined life condition.

(Second Modification Example) The third reception unit 123 may further receive, as the operation condition, an ambient temperature around the speed reducer. For example, the third reception unit 123 may receive the ambient temperature from the user via the user terminal 200. Further, a temperature sensor may be attached at an appropriate position, for example, to the speed reducer, and the third reception unit 123 may receive the ambient temperature from the temperature sensor. The life estimating unit 130 may estimate the life of the speed reducer in consideration of the ambient temperature received by the third reception unit 123. For example, in a case where the life estimating unit 130 estimates the life using a life calculation equation, the life calculation equation may include the ambient temperature [°C] as a variable. According to the present modification example, it is possible to estimate the life of the speed reducer with higher accuracy.

(Third Modification Example) Although not particularly mentioned in the embodiment, the life estimating unit 130 may estimate a life of a lubricant sealed in the speed reducer, in other words, a replacement cycle of the lubricant. That is, the life estimating unit 130 may estimate the life of the lubricant sealed in the speed reducer in a case where the speed reducer specified by the speed reducer specifying unit 126, based on the designation received by the second reception unit 122, is incorporated into the joint of the robot having the specification received by the first reception unit 121, and then the robot is operated under the operation condition received by the third reception unit 123. The life estimating unit 130 may use a known or future available technique to estimate the life of the lubricant.

In the embodiments and the modification examples, the speed reducer selection assistive device 100 has been mainly described as a device. However, the present invention can also be regarded as a speed reducer selection assistive method including each step executed by the speed reducer selection assistive device 100, as an invention of a program for causing the speed reducer selection assistive device 100 to execute each step, or as an invention of a storage medium storing the program.

### Industrial Applicability

The present invention can be used for a speed reducer selection assistive device.

### Reference Signs List

- 10: speed reducer selection assistive system
- 100: speed reducer selection assistive device
- 121: first reception unit
- 122: second reception unit
- 123: third reception unit
- 127: analysis unit
- 129: analysis result providing unit
- 130: life estimating unit
- 131: estimated life providing unit
- 132: speed reducer proposing unit
- 141: speed reducer information storage unit

## Claims

1. A speed reducer selection assistive device comprising:
a storage unit that stores, in association with information enabling a type of a speed reducer to be specified, characteristic information of the speed reducer;
a first reception unit that receives specification information of a robot;
a second reception unit that receives designation of a speed reducer to be incorporated into each joint of the robot;
a third reception unit that receives an operation condition of the robot;
a life estimating unit that estimates a life of the speed reducer in a case where the robot in which the designated speed reducer is incorporated into each joint is operated under a designated operation condition; and
an estimated life providing unit that provides a user with an estimation result by the life estimating unit.

2. The speed reducer selection assistive device according to claim 1,
wherein the characteristic information changes according to a situation change of the speed reducer, and
the speed reducer selection assistive device further includes an analysis unit that analyzes behavior of the robot in which the designated speed reducer is incorporated into each joint, and
an analysis result providing unit that provides the user with an analysis result by the analysis unit.

3. The speed reducer selection assistive device according to claim 1,
wherein the life estimating unit estimates lives of a plurality of sites of the speed reducer.

4. The speed reducer selection assistive device according to claim 1,
wherein the third reception unit receives an ambient temperature as the operation condition of the robot.

5. The speed reducer selection assistive device according to claim 1, further comprising:
a speed reducer proposing unit that proposes another speed reducer different from the designated speed reducer to the user in a case where the estimated life does not satisfy a predetermined condition.

6. A speed reducer selection assistive device comprising:
a storage unit that stores, in association with information enabling a type of a speed reducer to be specified, characteristic information of the speed reducer;
a first reception unit that receives specification information of a robot;
a third reception unit that receives an operation condition of the robot;
a life estimating unit that estimates lives of a plurality of speed reducers in a case where the robot is operated under a designated operation condition; and
a speed reducer proposing unit that proposes, based on estimation results of the lives by the life estimating unit, one or a plurality of speed reducers to a user.

7. The speed reducer selection assistive device according to claim 6,
wherein the third reception unit receives a required life, and
the speed reducer proposing unit proposes a speed reducer of which the estimated life is equal to or larger than the required life.
